# EUROPEAN PATENT APPLICATION

(11) **EP 4 102 699 A1**
(43) Date of publication of application: **14.12.2022**
(21) Application number: 21178752.8
(22) Date of filing: 10.06.2021
(51) Int. Cl.: H02M 1/00, H02M 1/44, H02M 7/06, G01R 15/16, G01R 23/02, G01R 23/10, H02M 3/335

(54) **MEASUREMENT OF PERFORMANCE DATA OF LED POWER SUPPLIES**

(71) Applicant: Tridonic GmbH & Co. KG, 6851 Dornbirn (AT)
(72) Inventor: Laudani, Giuseppe Attilio, 6850 Dornbirn (AT)
(74) Representative: Rupp, Christian

(57) **Abstract**

Disclosed is a power supply (1) for an LED load (2). The power supply (1) comprises an isolating transformer (13) configured to inductively transfer power of a rectified mains supply (17) from a primary side (11) of the power supply (1) to a secondary side (12) of the power supply (1); and a first capacitor (18) capacitively coupling the primary and secondary sides (11, 12). The secondary side (12) of the power supply (1) comprises output terminals (16) connectable to the LED load (2); an LED driver (15) configured to drive the LED load (2) using the power transferred to the secondary side (12); and a second capacitor (19) serially connected to the first capacitor (18). The first and second capacitors (18, 19) are configured to capacitively couple a ground potential of the primary side (11) and a ground potential of the secondary side (12). The secondary side (12) of the power supply (1) further comprises a processing unit (22) configured to evaluate a voltage across the second capacitor (19) and to determine presence and/or a value, e.g. a frequency, of a voltage of the mains supply (17) based on the voltage across the second capacitor (19). This provides a low-complexity and low-cost AC frequency measurement for LED power supplies.

## Description

### Technical Field

The present disclosure relates to electric power conversion and, in particular, to a power supply and a method of operating the same.

### Background Art

D4i is an extension of the DALI-2 certification program for conformance with Digital Addressable Lighting Interface (DALI) standards. D4i-certified LED drivers have a compulsory set of features related to smart-data capabilities and power-supply requirements. The latter includes standardized collection and storage of diagnostic data in accordance with the mandatory DALI (standard) Part 253, which specifies methods that allow for real-time driver operation information, such as performance data, to be read back to a centralized controller and thus enabling predictive maintenance. Inter alia, the performance data may include the Driver External Supply Frequency, i.e., the frequency of external supply voltage.

Therefore, D4i-certified power supplies need to measure the frequency of their AC mains supply, in particular.

Conventional frequency measurement approaches include deploying a step-down transformer or an extra winding in a flyback transformer, in connection with a frequency counter circuit. Since the measurement is carried out by a microcontroller generally placed on a Safety Extra-Low Voltage (SELV) side of the power supply, this implies respecting reinforced insulation, creepage and clearance requirements with higher cost and space demand.

### Summary

It is thus an objective of the present disclosure to provide a power supply capable of measuring the AC mains frequency by using a low-voltage, low-cost solution, and avoiding expensive and space-taking reinforced insulation components.
The invention is defined by the appended independent claims. Preferred embodiments are set forth in the dependent claims and in the following description and drawings.

A first aspect of the present disclosure relates to a power supply for an LED load. The power supply comprises: an isolating transformer configured to inductively transfer power of a rectified mains supply from a primary side of the power supply to a secondary side of the power supply; and a first capacitor capacitively coupling the primary and secondary sides. The secondary side comprises: output terminals connectable to the LED load; an LED driver configured to drive the LED load using the power transferred to the secondary side; and a second capacitor serially connected to the first capacitor. The first and second capacitors are configured to capacitively couple a ground potential of the primary side and a ground potential of the secondary side. The secondary side further comprises a processing unit configured to evaluate a voltage across the second capacitor and to determine presence and/or a value, e.g. a frequency, of a voltage of the mains supply based on the voltage across the second capacitor.

The secondary side may further comprise an operational amplifier configured to amplify the voltage across the second capacitor.

The operational amplifier may further be configured to amplify the voltage across the second capacitor by an open-loop gain that decreases with rising frequency.

The amplified voltage may comprise a square waveform.

The processing unit may further be configured to determine the value of the voltage of the mains supply based on the voltage across the second capacitor within a reference time period comprising a plurality of cycles of the square waveform.

The capacitance of the second capacitor may comprise a multiple of the capacitance of the first capacitor.

The multiple may comprise two or more orders of magnitude.

The first capacitor may comprise a class Y capacitor.

The secondary side further comprising a bandpass filter having a pass bandwidth substantially centered at a fundamental frequency of the mains supply and configured to smoothen and zero-offset the voltage across the second capacitor.

The processing unit may further be configured to record the determined value of the voltage of the mains supply in a memory.

The processing unit may further be configured to transfer the recorded value to a communication interface, preferably via a transfer circuit over an isolation barrier between the primary side and the secondary side.

The communication interface may be configured to perform communication based on a wire-less or wire-bound communication standard, in particular based on a DALI standard.

A second aspect of the present disclosure relates to a luminaire, comprising a power supply of the first aspect or any of its implementations; and an LED load connected to output terminals of the power supply.

A third aspect of the present disclosure relates to a method of operating a power supply for an LED load. The power supply comprises a primary side and a secondary side. The method comprises: connecting the LED load to output terminals of the power supply arranged on the secondary side; inductively transferring power of a rectified mains supply from the primary side to the secondary side; driving the LED load using the power transferred to the secondary side; capacitively coupling a ground potential of the primary side and a ground potential of the secondary side using a first capacitor capacitively coupling the primary and secondary sides and a second capacitor arranged on the secondary side and serially connected to the first capacitor; evaluating a voltage across the second capacitor; and determining a presence and/or a value, e.g. a frequency, of a voltage of the mains supply based on the voltage across the second capacitor.

The method may be performed by a power supply of the first aspect or any of its implementations.

### Advantageous Effects

The proposed solution takes advantage of a reinforced insulation component (class Y capacitor) already present in the circuit, but acting on the low-voltage side of it, without lowering the safety insulation characteristics provided by the class Y capacitor and without degrading the EMC/transient performances.

In accordance with the present disclosure, a capacitive divider is used to "sniff" an AC signal which has the same (or related) frequency of the AC mains frequency, but without being invasive for the normal functioning of the circuit.

The simplest solution uses only two components to "translate" the signal containing the AC mains frequency information into a square wave signal, which has a frequency related to the AC mains frequency, e.g. twice the frequency. A more complex extension of this circuit may use further circuitry to translate the square wave signal into a DC voltage proportional to the square wave frequency.

The proposed solution is a low-complexity and low-cost solution. Since only SELV-rated components are used, the cost is lower than frequency measuring techniques that read the frequency on the high-voltage side, as the latter implies using more expensive components with reinforced insulation characteristics.

Another advantage is that the technique is virtually non-invasive for the normal operational performance of the circuit (negligible or zero impact on EMC, transient, etc.).

The resulting measurement is an "almost real-time" measurement of the AC mains frequency having a very short delay time (∼µs).

The solution works for other frequency systems as well (i.e., 60Hz systems for US, Western Japan, etc.). Furthermore, the solution also works for DC systems provided attention is dedicated to the grounding system to avoid the formation of ground loops. The frequency indication will be, in this case, equal to zero.

The technical effects and advantages described above in relation with the power supply equally apply to the method having corresponding features as well as to the luminaire comprising the power supply.

### Brief Description of Drawings

The above-described aspects and implementations will now be explained with reference to the accompanying drawings, in which the same or similar reference numerals designate the same or similar elements.

The features of these aspects and implementations may be combined with each other unless specifically stated otherwise.

The drawings are to be regarded as being schematic representations, and elements illustrated in the drawings are not necessarily shown to scale. Rather, the various elements are represented such that their function and general purpose become apparent to those skilled in the art.
- FIG. 1: illustrates a luminaire in accordance with the present disclosure, comprising a power supply in accordance with the present disclosure;
- FIG. 2: illustrates a bandpass filter in accordance with the present disclosure of the power supply;
- FIG. 3: illustrates a power supply in accordance with the present disclosure comprising a wirebound communication interface;
- FIG. 4: illustrates a power supply in accordance with the present disclosure comprising a wireless communication interface; and
- FIG. 5: illustrates a method in accordance with the present disclosure of operating a power supply for an LED load.

### Detailed Descriptions of Drawings

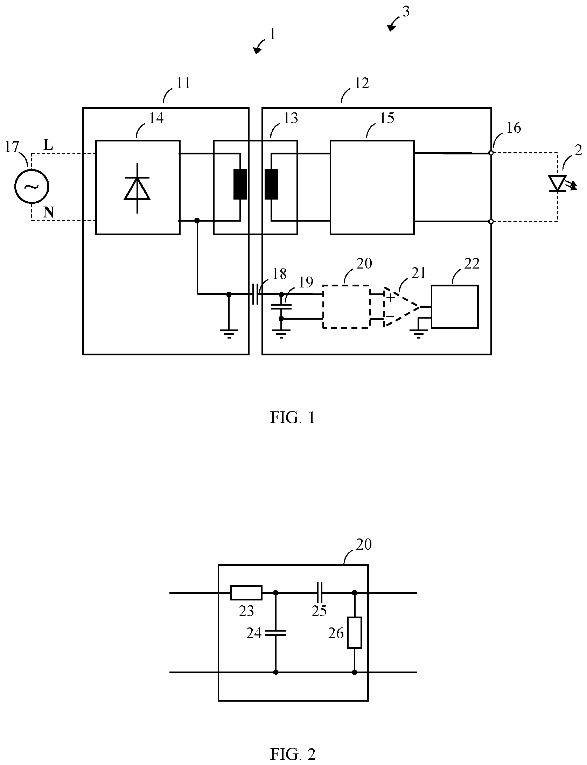

FIG. 1 illustrates a luminaire 3 in accordance with the present disclosure, comprising a power supply 1 in accordance with the present disclosure.

In accordance with FIG. 1, an LED load 2 may be connected to output terminals 16 of the power supply 1, and an AC mains supply 17 may be connected to input terminals of the power supply 1.

In the implementation of FIG. 1, the power supply 1 comprises a rectifier circuit 14, such as a full bridge rectifier, which effectively doubles a frequency of the AC mains supply 17.

The power supply 1 further comprises an isolating transformer 13 configured to inductively transfer power of the rectified mains supply 17 from a primary side 11 of the power supply 1 to a secondary side 12 of the power supply 1.

The power supply 1 further comprises a first capacitor 18 capacitively coupling the primary and secondary sides 11, 12. The first capacitor 18 is generally needed for electromagnetic compatibility (EMC) reasons and needs to possess reinforced insulation characteristics as it capacitively couples the high-voltage primary side (Vac,nom=220-240V) to the secondary side.

In particular, the first capacitor 18 may comprise a class-Y capacitor. Class-Y capacitors are also known as EMI/RFI suppression capacitors or "line to ground capacitors". They are safety-certified and generally used in AC line filtering in many electronic device applications. As used herein, EMI may refer to electromagnetic interference and RFI may refer to radio-frequency interference. For example, a capacitance of the first capacitor 18 may comprise 2,2 nF.

The secondary side 12 of the power supply 1 comprises output terminals 16 connectable to the LED load 2; an LED driver 15 configured to drive the LED load 2 using the power transferred to the secondary side 12; and a second capacitor 19 serially connected to the first capacitor 18.

The first and second capacitors 18, 19 are configured to capacitively couple a ground potential of the primary side 11 and a ground potential of the secondary side 12. In other words, the series connection of the first capacitor 18 and the second capacitor 19 represent a capacitive divider.

A capacitance of the second capacitor 19 may comprise a multiple of a capacitance of the first capacitor 18. Generally, the multiple may comprise two or more orders of magnitude. For example, the capacitance of the second capacitor 19 may comprise 1µF, resulting in a factor of approx. 500 times between the exemplary capacitances of the first capacitor 18 and the second capacitor 19.

In this implementation, the second capacitor 19 has a zero or negligible impact at the frequencies of interest for EMI, as it will present a very low impedance at very high frequencies.

For the same reason, the second capacitor 19 experiences a voltage which is approximately 500 times smaller during transient test. For example, it experiences only approximately a 4V pulse for a 2kV transient pulse. As such, the second capacitor 19 does not require to be HV rated and may be a SELV-rated capacitor, which means its physical size will not be large.

The capacitance of the second capacitor 19 may be trimmed according to the application, but the principle is to use a much larger capacitance in series with the first capacitor 18 (Class-Y capacitor) therefore, without being invasive for the normal functioning of the circuit.

The secondary side 12 of the power supply 1 may further comprise an operational amplifier 21 configured to amplify the voltage across the second capacitor 19. For example, the operational amplifier 21 may comprise a TLV9001 circuit.

Those skilled in the art will appreciate that an operational amplifier is a high-gain electronic voltage amplifier with differential input terminals and, usually, a single-ended output terminal, and produces an output potential relative to circuit ground (i.e., voltage) that is typically 100,000 times larger than a potential difference (i.e., voltage) between its input terminals. That is to say, the operational amplifier 21 is configured to behave as a "zero-crossing" detector or a "zero-threshold" comparator. In case of an AC voltage applied between the differential input terminals, the amplified voltage (i.e., the output voltage of the operational amplifier 21) may thus comprise a square waveform. For example, a fraction of the voltage of the mains supply 17 may result in a square waveform having a frequency of approximately 50 Hz. As another example, a fraction of the *rectified* mains voltage may result in a square waveform having a frequency of approximately 100 Hz. Ideally, no current is absorbed by the differential input of the operational amplifier 21 downstream of the second capacitor 19.

The operational amplifier 21 may further be configured to amplify the voltage across the second capacitor 19 in an open-loop fashion. In other words, the operational amplifier 21 is used in open-loop configuration to compare the voltage across the second capacitor 19 with the ground potential of the secondary side 2. This implies that the operational amplifier 21 has a gain that decreases with frequency after approximately few tens of Hz (dominant pole of the operational amplifier), depending on the particular component. As such, the operational amplifier 21 may already behave like a low-pass filter against higher harmonics and/or radio-frequency (RF) noise.

The secondary side 12 of the power supply 1 further comprises a processing unit 22, such as a microcontroller (µC), configured to evaluate a voltage across the second capacitor 19 and to determine presence and/or a value, e.g. a frequency, of a voltage of the mains supply 17 based on the voltage across the second capacitor 19. The µC may employ various techniques to detect the frequency of the square waveform, such as counting transitions from low to high signal level per reference time period, such as a second, and/or maintaining a time series of such counter values for averaging.

In particular, the µC may perform averaging over many samples to improve a precision of the measurement. Accordingly, the processing unit 22 may be configured to determine the value of the voltage of the mains supply 17 based on the voltage across the second capacitor 19 within a reference time period comprising a plurality of cycles of the square waveform.

The processing unit 22 may be configured to record the determined value of the voltage of the mains supply 17 in a memory (not shown).

FIG. 2 illustrates a bandpass filter 20 in accordance with the present disclosure of the power supply 1.

The above-mentioned square waveform may be related to the frequency of the AC mains supply 17, but may further include additional low- and high-frequency filtering components for removing undesired DC bias signals and/or harmonics and/or radio-frequency (RF) noise. As such, filtering may be required between the second capacitor 19 and the operational amplifier 20.

Thus the secondary side 12 of the power supply 1 may further comprise a bandpass filter 20 having a pass bandwidth substantially centered at a fundamental frequency of the mains supply 17 and configured to smoothen and zero-offset the voltage across the second capacitor 19.

In the example of FIG. 2, the bandpass filter 20 comprises an RC low-pass element 23, 24 and a CR high-pass element 25, 26. For example, the RC low-pass element 23, 24 may be implemented based on values of 100 kΩ and 10 nF, and the CR high-pass element 25, 26 may be realized based on values of 10 nF and 1 MΩ. This results in a passband between approx. 15 and 250 Hz, substantially centered at the frequency of the mains supply 17 (here: 50 Hz). RF noise spikes are thus reduced or removed. Any potential DC bias is removed, too.

As mentioned above, the mandatory DALI Part 253 specifies methods that allow for real-time driver operation information, such as performance data, to be read back to a centralized controller. To this end, the processing unit 22 may be configured to transfer the recorded value to a communication interface 27, 28. The communication interface 27, 28 may be configured to perform communication based on a wire-less or wire-bound communication standard, in particular based on a DALI standard.

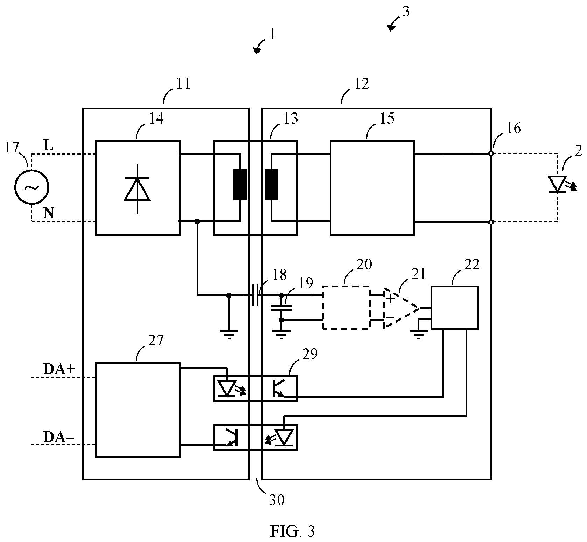

FIG. 3 illustrates a power supply 1 in accordance with the present disclosure comprising a wire-bound communication interface 27.

In the implementation of FIG. 3, the processing unit 22 is configured to transfer the recorded value to the wire-bound communication interface 27, such as a DALI interface, via a transfer circuit 29, such as an opto coupler, over an isolation barrier 30 between the primary side 11 and the secondary side 12. One transfer circuit 29 may be needed per direction of transfer. The exemplary opto couplers 29 of FIG. 3 are shown without any external circuitry for reasons of clarity and to leave open the particular implementation (inverting or non-inverting). The DALI interface is configured to provide DALI-based connectivity to the afore-mentioned centralized controller via a DALI communication bus.

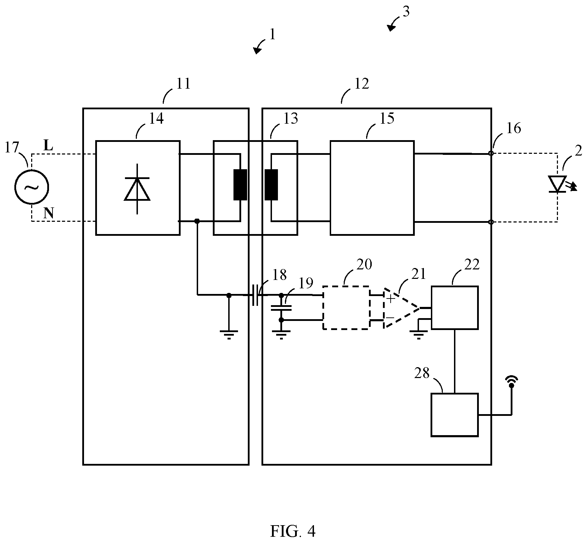

FIG. 4 illustrates a power supply 1 in accordance with the present disclosure comprising a wire-less communication interface 28.

In the alternative implementation of FIG. 4, the processing unit 22 is configured to transfer the recorded value to the wire-less communication interface 28, such as a Bluetooth low energy (BLE) interface. The BLE interface is configured to provide Bluetooth-based connectivity to the afore-mentioned centralized controller.

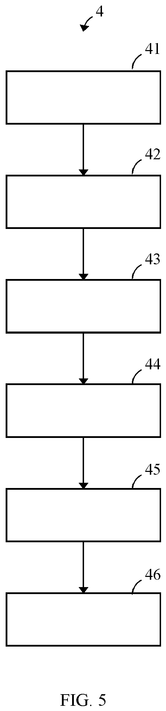

FIG. 5 illustrates a method 4 in accordance with the present disclosure of operating a power supply 1 for an LED load 2.

The method 4 may be performed by a power supply 1 of the first aspect or any of its implementations. The power supply 1 comprises a primary side 11 and a secondary side 12.

The method 4 comprises steps of:
- connecting 41 the LED load 2 to output terminals 16 of the power supply 1 arranged on the secondary side 12;
- inductively transferring 42 power of a rectified mains supply 17 from the primary side 11 to the secondary side 12;
- driving 43 the LED load 2 using the power transferred to the secondary side 12;
- capacitively coupling 44 a ground potential of the primary side 11 and a ground potential of the secondary side 12 using a first capacitor 18 capacitively coupling the primary and secondary sides 11, 12 and a second capacitor 19 arranged on the secondary side 12 and serially connected to the first capacitor 18;
- evaluating 45 a voltage across the second capacitor 19 and
- determining 46 a presence and/or a value, e.g. a frequency, of a voltage of the mains supply 17 based on the voltage across the second capacitor 19.

## Claims

1. A power supply (1) for an LED load (2), comprising
an isolating transformer (13) configured to inductively transfer power of a rectified mains supply (17) from a primary side (11) of the power supply (1) to a secondary side (12) of the power supply (1); and
a first capacitor (18) capacitively coupling the primary and secondary sides (11, 12);
the secondary side (12) comprising
output terminals (16) connectable to the LED load (2);
an LED driver (15) configured to drive the LED load (2) using the power transferred to the secondary side (12);
a second capacitor (19) serially connected to the first capacitor (18), the first and second capacitors (18, 19) configured to capacitively couple a ground potential of the primary side (11) and a ground potential of the secondary side (12);
a processing unit (22) configured to evaluate a voltage across the second capacitor (19) and to determine presence and/or a value, e.g. a frequency, of a voltage of the mains supply (17) based on the voltage across the second capacitor (19).

2. The power supply (1) of claim 1,
the secondary side (12) further comprising an operational amplifier (21) configured to amplify the voltage across the second capacitor (19).

3. The power supply (1) of claim 2,
the operational amplifier (21) further configured to amplify the voltage across the second capacitor (19) by an open-loop gain that decreases with rising frequency.

4. The power supply (1) of claim 2 or claim 3,
the amplified voltage comprising a square waveform.

5. The power supply (1) of claim 4,
the processing unit (22) configured to determine the value of the voltage of the mains supply (17) based on the voltage across the second capacitor (19) within a reference time period comprising a plurality of cycles of the square waveform.

6. The power supply (1) of any one of the preceding claims,
a capacitance of the second capacitor (19) comprising a multiple of a capacitance of the first capacitor (18).

7. The power supply (1) of claim 6,
the multiple comprising two or more orders of magnitude.

8. The power supply (1) of any one of the preceding claims,
the first capacitor (18) comprising a class Y capacitor.

9. The power supply (1) of any one of the preceding claims,
the secondary side (12) further comprising a bandpass filter (20) having a pass bandwidth substantially centered at a fundamental frequency of the mains supply (17) and configured to smoothen and zero-offset the voltage across the second capacitor (19).

10. The power supply (1) of any one of the preceding claims,
the processing unit (22) configured to record the determined value of the voltage of the mains supply (17) in a memory.

11. The power supply (1) of claim 10,
the processing unit (22) configured to transfer the recorded value to a communication interface (27, 28), preferably via a transfer circuit (29) over an isolation barrier (30) between the primary side (11) and the secondary side (12).

12. The power supply (1) of claim 11,
the communication interface (27, 28) configured to perform communication based on a wire-less or wire-bound communication standard, in particular based on a DALI standard.

13. A luminaire (3), comprising
a power supply (1) of any one of the preceding claims; and
an LED load (2) connected to output terminals (16) of the power supply (1).

14. A method (4) of operating a power supply (1) for an LED load (2), the power supply (1) comprising a primary side (11) and a secondary side (12); the method (4) comprising
connecting (41) the LED load (2) to output terminals (16) of the power supply (1) arranged on the secondary side (12);
inductively transferring (42) power of a rectified mains supply (17) from the primary side (11) to the secondary side (12);
driving (43) the LED load (2) using the power transferred to the secondary side (12); capacitively coupling (44) a ground potential of the primary side (11) and a ground potential of the secondary side (12) using a first capacitor (18) capacitively coupling the primary and secondary sides (11, 12) and a second capacitor (19) arranged on the secondary side (12) and serially connected to the first capacitor (18);
evaluating (45) a voltage across the second capacitor (19) and
determining (46) a presence and/or a value, e.g. a frequency, of a voltage of the mains supply (17) based on the voltage across the second capacitor (19).

15. The method (4) of claim 14,
being performed by a power supply (1) of any one of the claims 1 to 12.
